# EUROPEAN PATENT SPECIFICATION

(11) **EP 2 741 318 B1**
(45) Date of publication and mention of the grant of the patent: **26.08.2020**
(21) Application number: 12815245.1
(22) Date of filing: 19.07.2012
(51) Int. Cl.: H01L 21/28, H01L 21/285, H01L 29/40, H01L 23/532, H01L 29/739, H01L 29/78, H01L 29/768, H01L 29/161, H01L 29/165, H01L 29/45, H01L 21/768

(54) **SEMICONDUCTOR ELEMENT AND METHOD FOR MANUFACTURING SEMICONDUCTOR ELEMENT**
HALBLEITERELEMENT UND HERSTELLUNGSVERFAHREN FÜR DAS HALBLEITERELEMENT
ÉLÉMENT SEMI-CONDUCTEUR ET SON PROCÉDÉ DE FABRICATION

(30) Priority: 19.07.2011 JP 2011157571
(43) Date of publication of application: 11.06.2014
(73) Proprietor: Kabushiki Kaisha Kobe Seiko Sho (Kobe Steel, Ltd.), Kobe-shi, Hyogo 651-8585 (JP)
(72) Inventor: MAEDA Takeaki, Hyogo 651-2271 (JP); OKUNO, Hiroyuki, Hyogo 651-2271 (JP); YOKOTA, Yoshihiro, Hyogo 651-2271 (JP)
(74) Representative: Müller-Boré & Partner Patentanwälte PartG mbB
(86) International application number: PCT/JP2012/068383
(87) International publication number: WO 2013/012050

(56) References cited:
- JP-A- 4 023 319
- JP-A- 4 280 424
- JP-A- 62 076 550
- JP-A- 2003 142 581
- JP-A- 2010 238 800
- JP-A- 2011 035 153
- JP-A- 2011 035 153
- US-A1- 2004 126 608

## Description

The present invention relates to a method for manufacturing a semiconductor element.

Recent years, insulated-gate (MOS) type semiconductor elements are widely used for power device which control large electric power. Examples of the MOS type semiconductor elements are such as IGBT (insulated gate bipolar transistor) and power MOSFET (power metal-oxide semiconductor field-effect transistor).

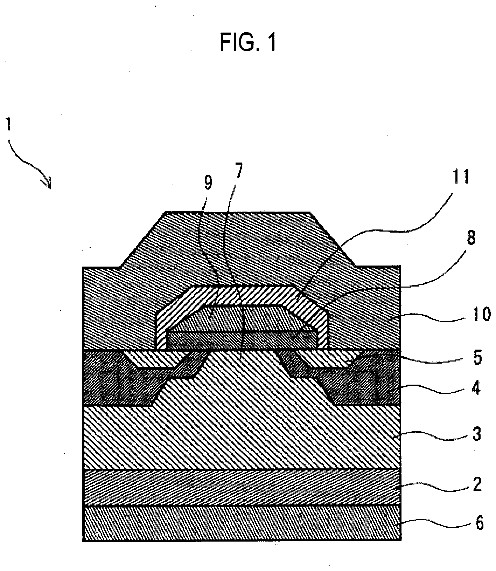

A general configuration of an IGBT as a typical MOS type semiconductor is explained hereinafter by referring to FIG. 1. An IGBT 1 illustrated in FIG. 1 comprises a p-type collector layer 2, an n-type base layer 3 fabricated on the collector layer 2, a p-type body region 4 fabricated in a spatially-segregated manner on the surface of the base layer 3, and an n-type emitter layer 5 fabricated on the surface of each of the body region. The collector layer 2, the base layer 3, the body region 4, and the emitter layer 5 are usually fabricated within the body of a substrate. A collector electrode 6 is connected to the collector layer 2. Within the base layer 3, a region of the n-type base layer configured in between two emitter layers 5 is a channel region 7. The IGBT 1 further has a gate insulating film 8 and a gate electrode 9 fabricated on the surface of the channel region 7 in that order. On a surface of the emitter layer 5, an emitter electrode 10 is also fabricated. The emitter electrode 10 and the gate electrode 9 are electrically insulated from each other by an interlayer dielectric film 11. The collector electrode 6 is directly fixed by a soldering layer and electrically connected to a circuit board or the like. Connected to the surface of the emitter electrode 10 are metal wires and ribbons through which the electrode is electrically connected with external terminal. An Al-based electrode comprising pure Al or an Al alloy is used for electrodes such as the collector electrode 6 and others.

N-type semiconductor regions such as base layer 3 and emitter layer 5, and p-type such as collector layer 2 and body region 4 in IGBT 1 are fabricated for example by ion-implantation of elements such as phosphorus (P), arsenic (As), and B (boron) in a substrate comprising Si, followed by a heat treatment for activation. The ion-implantation is conducted at certain dose amount, acceleration voltage, and implantation angle prescribed for each of the regions, followed by activation heat treatment at temperatures and durations predetermined for each of the regions. Specifically, in the manufacturing process of the IGBT 1, for example an ion-implantation is carried out to the collector layer 2 from the back side of the substrate after fabricating an emitter electrode 10 on the surface of the substrate. Subsequently, activation of the implanted ions is promoted by carrying out a heat treatment at 450 °C or lower. In a case where an electrical connection through a soldering layer is included, the device may be heated to about 250 °C for a reflow process.

In such a manufacturing process, the higher the temperature of the heat treatment, the more the interdiffusion of atoms is enhanced across an interface between an electrode and a silicon semiconductor region adjacent with each other. Occasionally used for the electrode to prevent the interdiffusion is an Al - Si alloy in which silicon of one to a few percent is contained. However, even if such an alloy is used, the aforementioned interdiffusion cannot be circumvented for a heat treatment at 450 °C or higher temperatures. Patent literature 1, for example, describes a heat treatment at 800 °C to 950 °C for the purpose of activation of a collector layer. The heat treatment at such high temperatures, however, is restricted to be conducted prior to fabricating an electrode. Once an electrode is fabricated, the heat treatment is carried out up to about 450 °C, and no description is found in the literature referring to heat treatment at higher temperatures.

As described above, when a heat treatment to activate collector layer is conducted for devices on which an Al-based film is deposited, the heat treatment at 450 °C or above causes interdiffusion of atoms between an electrode and Si in contact with each other. In case the heat treatment is conducted at relatively low temperatures, other kinds of problems such as prolonged period of time of several hours to activate the collector layer and insufficient activation of the implanted ions may arise.

As a technology to suppress the interdiffusion, patent literature 2 discloses an approach to insert a nitride layer as a diffusion barrier layer at the interface of an Al-base electrode with a semiconductor region. The nitride layer comprising insulating SiN or AlN or the like causes an increase in contact resistance and electrical power loss. It is possible to reduce the contact resistance to some extent by for example a thin the nitride layer up to 10 nm or less so as to exert the tunneling effect or the like. It is, however, of limited effectiveness because the nitride is inherently an insulator. Moreover, the thinner the nitride layer, the more the interdiffusion. The suppression of the thermal diffusion and contact resistance are in a tradeoff relation. In order to put the approach in practice, it is thus necessary to precisely control the thickness of the nitride layer in a well-balanced manner, which is, however, extremely difficult in reality.

Patent literature 3 describes a thin film transistor substrate and a display device.

Patent literature 4 describes an electronic device, a method for manufacturing the same and a sputtering target.

Patent literature 1: Japanese Patent Application Publication No. 2007-242699
Patent literature 2: Japanese Patent Application Publication No. 2008-10801
Patent literature 3: Japanese Patent Application Publication No. 2011-035153
Patent literature 4: US 2004/0126608 A1

The present invention has been made in light of the circumstances described above. It is an object of the present invention to provide a method for manufacturing a semiconductor element in which interdiffusion of atoms between a semiconductor region and an electrode is suppressed and rise of the contact resistance is avoided even when the semiconductor element is exposed to a high temperature during fabrication process or others.

The present invention provides a method for manufacturing a semiconductor element described below.

(1) A manufacturing method of a semiconductor element comprising a semiconductor region including silicon,
an electrode including aluminum, and
a diffusion barrier layer including germanium and silicon between the semiconductor region and the electrode;
wherein the diffusion barrier layer and the electrode are formed by the heat treatment of the aluminum alloy film containing 0.1 atomic percent or more and 3 atomic percent or less of germanium,
an amount of germanium contained in the diffusion barrier layer is 20 atomic percent or more and 50 atomic percent or less,
a ratio of the amount of silicon to the amount of germanium in the diffusion barrier layer is 0.3 or more and 3.0 or less, and
a thickness of the diffusion barrier layer is 1 nm or more and 5 nm or less, the manufacturing method comprising;
a process step to form an aluminum alloy comprising 0.1 atomic percent or more and 3 atomic percent or less of germanium on a surface of a semiconductor region containing silicon, and
a process step to conduct a heat treatment of the semiconductor region on which the aluminum alloy is formed,
wherein the temperature of the heat treatment is 450°C or higher and the duration of the heat treatment is 5 minutes or longer.

(2) The manufacturing method according to (1), wherein the semiconductor element is further characterized in that the amount of germanium contained in the diffusion barrier layer is 20 atomic percent or more and 30 atomic percent or less.

In the semiconductor element manufactured by the manufacturing method according to the present invention, interdiffusion of atoms between a semiconductor region and an electrode (aluminum alloy film) is suppressed by the presence of a diffusion barrier including a given amount of germanium between a semiconductor region and an electrode. Moreover, in the semiconductor element, because of the presence of the diffusion barrier, rise of the contact resistance is avoided due to the presence of the diffusion barrier layer which comprises semiconductor germanium.

A diffusion barrier layer including germanium is formed between the semiconductor region and the aluminum alloy film via the heat treatment in the manufacturing method. It becomes possible to suppress interdiffusion of atoms between the semiconductor region and the aluminum alloy film (electrode) during the heat treatment or the like, accordingly.

The contained amount of each element (atomic percent) is data acquired by elemental analysis using energy dispersive X-ray analysis (EDX). A "part" of the diffusion barrier layer means a field of measurement in the analysis. The thickness of the diffusion barrier layer is an average value of those measured at arbitrary 5 points by using a transmission electron microscope (TEM).

As explained hereinbefore, in a semiconductor element manufactured by the manufacturing method according to the present invention, interdiffusion of atoms between a semiconductor region and an electrode is suppressed and rise of the contact resistance is avoided even when the semiconductor element is subjected to high temperature. The semiconductor element may be preferably used for MOS type semiconductor elements or the like, accordingly. Further, the semiconductor element is efficiently fabricated by the manufacturing method.

[FIG. 1] A schematic cross-sectional view of a common IGBT.

[FIG. 2] A cross-sectional TEM micrograph depicting an interface between a semiconductor region and an electrode in a semiconductor element of an example.

Described in detail hereinafter are embodiments of a method for manufacturing a semiconductor element according to the present invention and a semiconductor element manufactured by the manufacturing method.

### (Semiconductor element)

A semiconductor element manufactured by the manufacturing method according to the present invention comprises a semiconductor region, an electrode, and a diffusion barrier layer between the semiconductor region and the electrode.

The semiconductor region includes silicon. The semiconductor region generally comprises a known semiconductor material such as silicon substrate and silicon carbide substrate, and the like, which contains silicon as a main constituent. The semiconductor region may include phosphorus, arsenic, boron, and so on in addition to silicon. In such a case, the amount of phosphorus, arsenic, boron, and the like is preferably in the range from 10¹⁶/cm³ to 10¹⁹/cm³.

The electrode is in contact with the semiconductor region via the diffusion barrier layer. The electrode is electrically connected to the semiconductor region because the diffusion barrier layer is not insulating as described hereinafter in detail.

The electrode includes aluminum as a main constituent. Generally-known pure aluminum and aluminum alloys may be used for the electrode. As the alloy element is not specifically limited, it may be silicon, copper, nitrogen, and rare-earth elements such as neodymium and yttrium. If silicon is included as an alloy element, the amount of silicon is preferably in the range from 0.5 to 1.0 atomic percent. If copper is included as an alloy element, the amount is preferably in the range from 0.1 to 0.5 atomic percent. If rare-earth group element is included as an alloy element, the amount is preferably in the range from 0.2 to 2.0 atomic percent.

The diffusion barrier layer lies between a semiconductor region and an electrode as described above. Specifically, if for example the semiconductor region is a collector layer and the electrode is a collector electrode which is electrically connected to the collector layer, the diffusion barrier layer lies between the collector layer and the collector electrode. Further, of the semiconductor region is an emitter layer and the electrode is an emitter electrode which is electrically connected to the emitter layer, the diffusion barrier layer lies between the emitter layer and the emitter electrode.

The diffusion barrier layer contains germanium and silicon. According to the semiconductor element which contains a diffusion barrier layer including germanium, interdiffusion of atoms between a semiconductor region and an electrode may be suppressed even when the semiconductor element is subjected to high temperature exceeding for example 450 °C.

Here, germanium is a semiconductor material having electrical resistivity of about 70 µΩcm at room temperature, which is close to those of metals. Therefore, even in a case where the diffusion barrier layer was consisting of only germanium, the contact resistance may be significantly reduced as compared to cases where the diffusion barrier comprises a conventional insulating material such as SiN. Moreover, due to the presence of the diffusion barrier comprising germanium in the semiconductor element, Si - Ge chemical bonds having covalent nature may be formed with silicon and germanium in the semiconductor region. As Si - Ge is a semiconductor, once being subjected to thermal process, aluminum of the electrode is naturally doped as an acceptor, and electrical resistance of the diffusion barrier layer is reduced.

### According to the semiconductor element which contains a diffusion barrier layer including germanium, the contact resistance can be reduced as compared to those having a conventional diffusion barrier layer, regardless of whether the diffusion barrier layer comprises of only germanium or it contains other element such as for example silicon or others. The contact resistance is not particularly dependent on thickness of the diffusion barrier layer. It is thus not very necessary to precisely control the thickness of the diffusion barrier layer according to the semiconductor element. The control condition of the fabrication process may be relaxed, which makes the formation of the diffusion barrier layer easier.

The lower limit of an amount of germanium contained in at least a part of the diffusion barrier layer is 20 atomic percent or more. The diffusion barrier layer can offer sufficient diffusion prevention performance by controlling the contained amount of germanium higher than the lower limit.

The upper limit of an amount of contained germanium is 50 atomic percent, and preferably 30 atomic percent, considering cost and other factors. It may be considered that stoichiometrically and substantially sufficient Si - Ge bonds are formed, adequate performance of diffusion prevention and low electrical resistance may be obtained even the amount of germanium is below the upper limit.

The diffusion barrier layer comprises silicon and may comprise aluminum in addition to germanium.

The lower limit of the amount of germanium contained in at least a part of the diffusion barrier layer is 20 atomic percent in the case which the diffusion barrier layer contains silicon. The upper limit in such case on the other hand is 50 atomic percent, and preferably 30 atomic percent. Further, the ratio of the amount of silicon to the amount of germanium in the part of the diffusion barrier layer is 0.3 or more and 3 or less, and preferably 0.5 or more and 2 or less. By controlling the amount of silicon contained in the diffusion barrier layer, sufficient Si - Ge bonding may be formed in the diffusion barrier layer, enhance the diffusion prevention property while suppressing the electrical resistance.

The lower limit of thickness of the diffusion barrier layer is 1 nm. The diffusion barrier layer can offer sufficient diffusion prevention performance by controlling the thickness larger than the lower limit.

If the thickness of the diffusion barrier layer is 1 nm or more and the amount of germanium contained in at least a part of the diffusion barrier layer is 20 atomic percent or more, the diffusion barrier shows near-flawless performance even if it is subjected to a heat treatment at for example 500 °C for 20 minutes.

The upper limit of thickness of the diffusion barrier layer is 5 nm, considering cost and other factors.

In a semiconductor element manufactured by the manufacturing method according to the present invention, interdiffusion of atoms between a semiconductor region and an electrode is suppressed and rise of the contact resistance is avoided even when the semiconductor element is subjected to high temperature. Therefore, by utilizing the present invention, a heat treatment for ion activation of a collector layer or the like may be conducted at 450 °C or higher temperatures during a fabrication process of, for example, IGBT. A heat treatment at such high temperatures shortens the process time and reduce the manufacturing cost. Further, according to the semiconductor element, the activation rate of the dopant which is ion-implanted to the collector layer or the like is enhanced by the high-temperature heat treatment, resulting in improved performance of the device. Furthermore, according to the semiconductor element, it is possible to suppress interdiffusion of atoms even in a case where a surge current is induced for some reasons during operation and the Joule heat induced soaring temperature locally, and the reliability is enhanced as an irreversible destruction is less likely to occur.

### (Manufacturing method of a semiconductor element)

The manufacturing method of a semiconductor element comprising a semiconductor region including silicon, an electrode including aluminum, and a diffusion barrier layer including germanium and silicon between the semiconductor region and the electrode, wherein the diffusion barrier layer and the electrode are formed by the heat treatment of the aluminum alloy film containing 0.1 atomic percent or more and 3 atomic percent or less of germanium, an amount of germanium contained in the diffusion barrier layer is 20 atomic percent or more and 50 atomic percent or less, a ratio of the amount of silicon to the amount of germanium in the diffusion barrier layer is 0.3 or more and 3.0 or less, and a thickness of the diffusion barrier layer is 1 nm or more and 5 nm or less, according to the present invention comprises;
(1) a process to fabricate an aluminum alloy film which contains germanium on a surface of a semiconductor region comprising silicon, and
a process to conduct a heat treatment to the semiconductor region on which the aluminum alloy film is fabricated.

The aluminum alloy film works as an electrode of the fabricated semiconductor element.

Germanium of an aluminum alloy film precipitates or incrassates at an interface by a heat treatment in the manufacturing method (1). A diffusion barrier comprising germanium is thereby formed between an semiconductor region and an aluminum alloy film during a heat treatment. Interdiffusion of atoms between the semiconductor region and the aluminum alloy film during the heat treatment and the like may be suppressed accordingly. Moreover, according to the manufacturing method (1), thickness of the formed diffusion barrier layer can be readily controlled by the amount of germanium contained in the aluminum alloy film. In such a case, formation of a thin diffusion barrier layer of 5 nm in thickness, for example, can be conducted relatively easily while suppressing used amount of costly germanium.

In the semiconductor element obtained by the method for manufacturing a semiconductor element of the present invention, interdiffusion of atoms between a semiconductor region and an electrode is suppressed and rise of the contact resistance is avoided even with the presence of the diffusion barrier layer.

The present invention does not limit the method of deposition of the Al alloy film. For example, publicly known method such as sputtering and evaporation may be used.

The amount of germanium contained in the Al alloy film is 0.1 atomic percent or more and 3 atomic percent or less.

The method of the heat treatment is not particularly limited, and heretofore known method may be adopted. The heat treatment may be conducted as an activation process after an ion-implantation to a semiconductor region, or may be conducted independently.

Temperature and duration of the heat treatment are as follows. As for the temperature, it is 450 °C or higher and preferably 600 °C or lower, more preferably 550 °C or lower. As for the duration, it is 5 minutes or longer. The duration may be set to 1 hour or shorter, preferably 30 minutes or longer and 1 hour or shorter.

Meanwhile, other than the above-described process such as for example ion-implantation, a publicly known method may be adopted for the fabrication of the semiconductor element.

### EXAMPLES

The present invention is more specifically described below by presenting examples. The present invention is not limited to these examples described below.

Amount of each composition and thickness of the diffusion barrier of the obtained semiconductor were measured using methods described below.

### (Amount of composition)

Amount of each composition was determined by EDX line analyses. For the ED line analyses, a field emission transmission electron microscope (FE-TEM) (HF-2000 supplied by Hitachi, Ltd.) and an EDX analysis device (Sigma supplied by Kevex Corp.) attached to the FE-TEM were used. Measurement data were acquired at points at intervals of approximately 5nm for the EDX line analyses.

It is noted that while the diameter of incident electron beam in the used microscope is about 1 - 2 nm, it spreads about due to electron beam scattering in the specimen and the detection area expands. In addition, a margin of error of approximately 10 % is inherent in the semi-quantitative evaluation of EDX analyses. Therefore, absolute value of the amount of each composition should be interpreted with an attention to the fact that it has not only an aspect of absolute value of measured data but also relative significance of the line analyses data.

### (Thickness of layer)

By using a field emission transmission electron microscope (FE-TEM) (HF-2000 supplied by Hitachi, Ltd.), thicknesses of the diffusion barrier layer were measured at arbitrary 5 points, and their average value was calculated.

### (Example 1)

On the surface of a monocrystalline silicon substrate with (100) plane direction as the semiconductor region, an aluminum alloy film containing 0.5 atomic percent germanium was deposited by magnetron sputtering. A heat treatment was subsequently conducted at 500 °C for 20 minutes in an inert gas (N2) atmosphere. In this way, a diffusion barrier layer was formed between the silicon substrate (semiconductor region) and the aluminum alloy film (electrode) to obtain a semiconductor element of example 1.

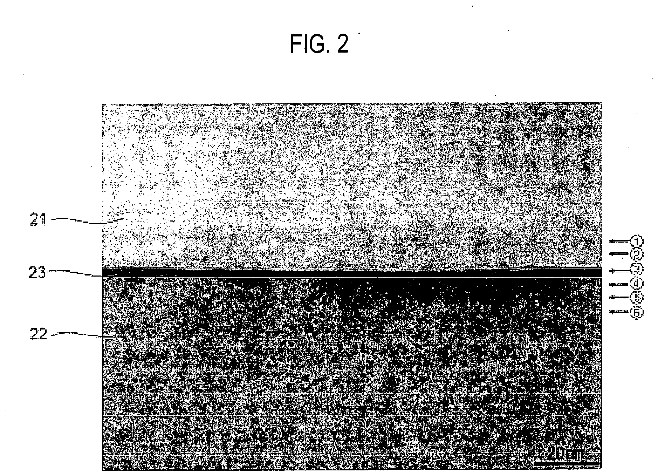

Amount of each composition and thickness of the diffusion barrier layer of the obtained semiconductor were measured using methods described above. The amount of each composition is shown in Table 1. A cross-sectional TEM image is shown in FIG. 2. Each of "point" in Table 1 corresponds to the position indicated by each of arrows illustrated in FIG. 2. The thickness of the diffusion barrier layer was 3.0 nm.

**Table 1**

| Point | Al (atomic %) | Si (atomic %) | Ge (atomic %) |
|---|---|---|---|
| ① | 97.6 | 1.8 | 0.6 |
| ② | 97.2 | 2.2 | 0.6 |
| ③ | 51.6 | 24.9 | 23.5 |
| ④ | 3.0 | 6.2 | 0.8 |
| ⑤ | 2.1 | 97.5 | 0.4 |
| ⑥ | 1.5 | 98.2 | 0.3 |

As shown in the cross-sectional TEM picture of FIG. 2, it was confirmed that a diffusion barrier 23 was formed between an electrode 21 (Al) and a semiconductor region 22 (Si). Interdiffusion of Al and Si was not observed.

The diffusion barrier layer 23 may be considered a solid layer formed by Si - Ge bond of covalent nature, by aggregation of Ge contained in the Al alloy film to the interface of the semiconductor region from a very initial stage of a heat treatment. If there was an interface where Al and Si are in direct contact with each other even partially during the heat treatment, the diffusion should have occurred as the diffusion rates of Al and Si are very high. By the fact that no trace of such diffusion was observed, it can be considered that a diffusion barrier layer was formed from a very initial stage of a heat treatment, Ge is incrassated at the interface between Al and Si once it is subjected to a heat treatment, and that Ge or Ge - Si bonds play the role of diffusion prevention.

The semiconductor element manufactured according to the manufacturing method of the present invention is preferably used for the MOS type semiconductor elements such as IGBT and power MOSFET.

### Description of Reference Numerals and Signs

- 1: IGBT
- 2: Collector layer
- 3: Base layer
- 4: Body region
- 5: Emitter layer
- 6: Collector electrode
- 7: Channel region
- 8: Gate insulating film
- 9: Gate electrode film
- 10: Emitter electrode
- 11: Interlayer dielectric film
- 21: Electrode (Al)
- 22: Semiconductor region (Si)
- 23: Diffusion barrier layer

## Claims

1. A manufacturing method of a semiconductor element comprising a semiconductor region including silicon,
an electrode including aluminum, and
a diffusion barrier layer including germanium and silicon between the semiconductor region and the electrode;
wherein the diffusion barrier layer and the electrode are formed by the heat
treatment of an aluminum alloy film containing 0.1 atomic percent or more and 3 atomic percent or less of germanium,
an amount of germanium contained in the diffusion barrier layer is 20 atomic percent or more and 50 atomic percent or less,
a ratio of the amount of silicon to the amount of germanium in the diffusion barrier layer is 0.3 or more and 3.0 or less, and
a thickness of the diffusion barrier layer is 1 nm or more and 5 nm or less, the manufacturing method comprising;
a process step to form the aluminum alloy comprising 0.1 atomic percent or
more and 3 atomic percent or less of germanium on a surface of a semiconductor region containing silicon, and
a process step to conduct a heat treatment of the semiconductor region on which the aluminum alloy is formed,
wherein the temperature of the heat treatment is 450°C or higher and the duration of the heat treatment is 5 minutes or longer.

2. The manufacturing method according to claim 1, wherein the semiconductor element is further **characterized in that** the amount of germanium contained in the diffusion barrier layer is 20 atomic percent or more and 30 atomic percent or less.

## Patentansprüche

1. Verfahren zur Herstellung eines Halbleiterelements umfassend einen Halbleiterbereich, der Silizium enthält,
eine Elektrode, die Aluminium enthält, und
eine Diffusionssperrschicht, die Germanium und Silizium enthält, zwischen dem Halbleiterbereich und der Elektrode;
wobei die Diffusionssperrschicht und die Elektrode durch die Wärmebehandlung eines Aluminiumlegierungsfilms gebildet werden, der 0,1 Atomprozent oder mehr und 3 Atomprozent oder weniger Germanium enthält,
eine in der Diffusionssperrschicht enthaltene Germaniummenge 20 Atomprozent oder mehr und 50 Atomprozent oder weniger beträgt,
ein Verhältnis der Menge an Silizium zu der Menge an Germanium in der Diffusionssperrschicht 0,3 oder mehr und 3,0 oder weniger beträgt, und
eine Dicke der Diffusionssperrschicht 1 nm oder mehr und 5 nm oder weniger beträgt, das Herstellungsverfahren umfassend;
einen Verfahrensschritt zum Bilden der Aluminiumlegierung, die 0,1 Atomprozent oder mehr und 3 Atomprozent oder weniger Germanium umfasst, auf einer Oberfläche eines Silizium enthaltenden Halbleiterbereichs, und
einen Verfahrensschritt zum Durchführen einer Wärmebehandlung des Halbleiterbereichs, auf dem die Aluminiumlegierung gebildet wird,
wobei die Temperatur der Wärmebehandlung 450°C oder höher ist und die Dauer der Wärmebehandlung 5 Minuten oder länger beträgt.

2. Herstellungsverfahren nach Anspruch 1, wobei das Halbleiterelement weiter **dadurch gekennzeichnet ist, dass** die Menge an Germanium, die in der Diffusionssperrschicht enthalten ist, 20 Atomprozent oder mehr und 30 Atomprozent oder weniger beträgt.

## Revendications

1. Procédé de fabrication d'un élément semi-conducteur comprenant une zone semi-conductrice contenant du silicium,
une électrode contenant de l'aluminium, et
une couche barrière de diffusion contenant du germanium et du silicium entre la zone semi-conductrice et l'électrode;
dans lequel la couche barrière de diffusion et l'électrode sont formées par le traitement thermique d'un film en alliage d'aluminium contenant 0,1 pourcent atomique ou plus et 3 pourcents atomiques ou moins de germanium,
la quantité de germanium contenue dans la couche barrière de diffusion est de 20 pourcents atomiques ou plus et de 50 pourcents atomiques ou moins,
le rapport de la quantité de silicium à la quantité de germanium dans la couche barrière de diffusion est de 0,3 ou plus et de 3,0 ou moins, et
l'épaisseur de la couche barrière de diffusion est de 1 nm ou plus et de 5 nm ou moins, le procédé de fabrication comprenant:
une étape de processus pour former l'alliage d'aluminium comprenant 0,1 pourcent atomique ou plus et 3 pourcents atomiques ou moins de germanium à la surface d'une zone semi-conductrice contenant du silicium, et
une étape de processus pour effectuer un traitement thermique de la zone semi-conductrice sur laquelle l'alliage en aluminium est formé,
dans lequel la température du traitement thermique est de 450°C ou plus et la durée du traitement thermique est de 5 minutes ou plus.

2. Procédé de fabrication selon la revendication 1, dans lequel l'élément semi-conducteur est en outre **caractérisé en ce que** la quantité de germanium contenue dans la couche barrière de diffusion est de 20 pourcents atomiques ou plus et de 30 pourcents atomiques ou moins.
